Europäisches Patentamt

**European Patent Office**

Office européen des brevets

(11) Numéro de publication: **0 355 114 B1**

(12) **FASCICULE DE BREVET EUROPEEN**

(45) Date de publication de fascicule du brevet: **13.10.93** (51) Int. Cl.⁵: **G01N 22/02**

(21) Numéro de dépôt: **88903857.6**

(22) Date de dépôt: **20.04.88**

(86) Numéro de dépôt internationale :
**PCT/FR88/00191**

(87) Numéro de publication internationale :
**WO 88/08529 (03.11.88 88/24)**

(54) **DISPOSITIF DE MESURE, EN UNE PLURALITE DE POINTS, DU CHAMP MICRO-ONDE DIFFRACTE PAR UN OBJET.**

(30) Priorité: **21.04.87 FR 8705597**

(43) Date de publication de la demande:
**28.02.90 Bulletin 90/09**

(45) Mention de la délivrance du brevet:
**13.10.93 Bulletin 93/41**

(84) Etats contractants désignés:
**AT BE CH DE FR GB IT LI LU NL SE**

(56) Documents cités:
**EP-A- 0 065 455**
**EP-A- 0 069 628**
**EP-A- 0 217 111**
**US-A- 4 634 968**

(73) Titulaire: **CENTRE NATIONAL DE LA RECHER-
CHE SCIENTIFIOUE (CNRS)
15, Ouai Anatole France
F-75700 Paris Cedex 07(FR)**

(72) Inventeur: **BERTHAUD, Patrice
24, rue Jacques-Decour
F-92150 Suresnes(FR)**
Inventeur: **BOLOMEY, Jean-Charles
6, rue Berthollet
F-75005 Paris(FR)**

(74) Mandataire: **Bloch, Gérard et al
2, square de l'Avenue du Bois
F-75116 Paris (FR)**

Rank Xerox (UK) Business Services
(3.10/3.6/3.3.1)

## Description

La présente invention a pour objet un dispositif de mesure, en une pluralité de points, du champ micro-onde diffracté par un objet illuminé par une source de rayonnement micro-onde à une fréquence, et comprenant :

- en chacun desdits points, une antenne de type doublet électrique, chargée en son centre par une diode,
- lesdites antennes doublets sont disposées le long d'au moins une ligne,
- des moyens collecteurs du rayonnement micro-onde diffracté, délivrant un signal micro-onde collecté,
- des moyens générateurs d'un signal basse fréquence,
- des moyens multiplexeurs, disposés entre lesdits moyens générateurs et chacune desdites diodes, et,
- des moyens pour commander lesdits moyens multiplexeurs de façon à ce qu'au moins une desdites diodes soit polarisée par ledit signal basse fréquence, et pour, en réponse audit signal basse fréquence et audit signal micro-onde collecté, engendrer un signal représentatif du champ micro-onde au point où se trouve ladite antenne doublet chargée par ladite diode polarisée.

Un tel dispositif peut être utilisé pour de nombreuses applications industrielles, et en particulier pour le contrôle non destructif d'objets susceptibles de présenter certains défauts, ou encore de matériaux ou de produits ayant subi une transformation telle que séchage, décongélation ou polymérisation, par exemple, afin de vérifier les résultats de cette transformation.

En effet, il est connu qu'un corps illuminé par une source de rayonnement micro-onde diffracte ce rayonnement d'une manière que dépend évidemment de sa forme, mais aussi de la constante diélectrique et de la conductivité en tout point de son volume. Ces deux dernières quantités dépendant évidemment de la structure interne du corps, il est donc possible d'effectuer un contrôle nondestructif de la structure interne d'un corps en analysant la diffraction d'un champ micro-onde illuminant ce corps.

Par champ diffracté, on entend ici soit le champ transmis à travers le corps, soit le champ réfléchi par celui-ci, de telle sorte que l'analyse de la diffraction peut s'effectuer soit en transmission, soit en réflexion, soit les deux à la fois.

C'est ainsi que l'on peut, à titre d'exemple, analyser les défauts d'une planche de bois, contrôler le degré et l'homogénéité du séchage d'une plaque ou d'une couche de plâtre, ou d'une feuille de papier, vérifier le déroulement et le résultat de la polymérisation d'un matériau plastique, ou apprécier le stade de décongélation de denrées alimentaires.

On connait déjà un dispositif de mesure de ce type, décrit dans le brevet américain n° 4 552 151. Dans ce dispositif, les antennes doublets sont reliées bout à bout, pour former les colonnes d'une "rétine matricielle", c'est-à-dire que l'ensemble des antennes doublets forme un panneau rectangulaire. Les moyens collecteurs sont constitués par un empilage de guides d'ondes, chacun en forme de cornet et l'ensemble est commandé pour que l'on puisse mesurer successivement la valeur du champ en tout point du panneau.

Un tel dispositif bidimensionnel est cependant assez encombrant car la longueur de chaque cornet est de l'ordre de grandeur de la plus grande dimension de son ouverture, qui définit sensiblement la longueur maximale d'analyse. Ce dispositif est, de plus, d'un prix de revient relativement élevé, et il est relativement complexe à mettre en oeuvre, notamment compte-tenu de la nécessité d'utiliser un multiplexeur micro-onde. Aussi, s'il convient bien pour des applications biomédicales, ou des applications de laboratoire, il est mal adapté aux applications industrielles du type ci-dessus.

La présente invention vise à pallier les inconvénients précédents en procurant un dispositif de mesure compact, de faible coût et de fonctionnement rapide et simple, bien adapté au milieu industriel.

A cet effet, la présente invention a pour objet un dispositif de mesure du type défini ci-dessus, caractérisé par le fait que :

- lesdits moyens collecteurs comprennent une unique structure de guidage micro-onde, disposée le long de ladite ligne d'antennes doublets, du côté opposé audit objet, à une distance desdites antennes doublets,
- il est prévu, le long de ladite structure de guidage, une pluralité d'antennes de couplage à ladite structure de guidage, chaque antenne de couplage transformant le rayonnement micro-onde qu'elle reçoit en une onde guidée par ladite structure de guidage,
- une extrémité de ladite structure de guidage est pour-vue d'une terminaison et l'autre extrémité des moyens de conversion desdites ondes guidées en ledit signal micro-onde collecté,
- lesdites antennes de couplage sont disposées à des emplacements tels qu'elles rayonneraient toutes en phase si, ladite source étant éteinte, un unique signal micro-onde était appliqué auxdits moyens de conversion,
- ladite distance entre les antennes doublets et la structure de guidage est déterminée pour que soit créé, dans ces conditions, un champ uniforme sur ladite ligne d'antennes doublets.

Pour le dispositif de mesure de l'invention, du fait que les antennes doublets sont réparties sur une ligne, et du fait que les moyens collecteurs ne comprennent qu'une structure de guidage disposée le long de la même ligne, à quelques longueurs d'ondes des antennes doublets, l'encombrement et le prix de revient sont faibles. De plus, dans les applications industrielles mentionnées ci-dessus, l'objet que l'on examine est, dans la grande majorité des cas, un objet en défilement devant le dispositif de mesure. La disposition de la ligne d'antennes doublets sensiblement perpendiculairement à la direction de défilement permettra donc d'obtenir simplement une image de l'objet.

Avec le dispositif de l'art antérieur, l'encombrement dans la direction perpendiculaire au plan d'analyse est de l'ordre du mètre pour une longueur d'analyse du même ordre de grandeur, quelle que soit la longueur d'onde, alors que dans le dispositif de l'invention, elle est de l'ordre de quelques longueurs d'ondes, soit par exemple inférieure à 10 cm, pour une fréquence de travail de 9GHz. De plus, pour une même longueur du dispositif selon la ligne d'analyse, la zone utile est plus importante.

Dans le dispositif de l'invention, il est remarquable que, du fait de l'uniformité du champ qui serait créé par les antennes de couplage sur la ligne c'antennes doublets, on puisse disposer celles-ci selon un pas choisi uniquement en fonction de la finesse d'analyse souhaitée dans l'application considérée, sans se soucier de la périodicité de la propagation sur la structure de guidage. En d'autres termes, le pas des antennes doublets et le pas des antennes de couplage sont choisis indépendamment l'un de l'autre, ce qui confère au dispositif de mesure de l'invention une grande souplesse d'utilisation.

De plus, le dispositif de l'invention permet de mesurer les variations de l'amplitude et de la phase du champ micro-onde le long de la ligne d'antennes doublets, en vue d'une visualisation directe ou d'un traitement synthétique,ou de focaliser en des points intérieurs à l'objet. Dans ces deux derniers cas, on peut ainsi accéder à une représentation tomographique de l'objet.

Ainsi, le dispositif de l'invention, qui est très bien adapté pour le contrôle non destructif d'objets ou de matériaux en défilement en vue de l'asservissement de leur unité de production, est aussi adapté pour une analyse plus approfondie, effectuée en laboratoire, afin de permettre, par exemple, une meilleure compréhension du processus de transformation que subit l'objet.

Avantageusement, le volume situé entre ladite structure de guidage et lesdites antennes doublets est fermé par deux parois parallèles à ladite ligne, et recouvertes d'une couche de matériau absorbant les rayonnements à ladite fréquence micro-onde.

Avantageusement encore, il est prévu, entre ledit objet et lesdites antennes doublets un écran d'adaptation.

Les éléments précédents permettent une optimisation, à la fréquence micro-onde de travail, du dispositif, en évitant les fuites et des réflexions parasites du rayonnement micro-onde et en permettant l'adaptation et l'accord de l'ensemble d'antennes doublets.

La présente invention sera mieux comprise à l'aide de la description suivante de plusieurs formes de réalisation du dispositif de mesure de l'invention, faite en se référant aux dessins annexés, sur lesquels :

- la figure 1 représente une vue en perspective du dispositif de l'invention, utilisé pour la détection de défauts dans le bois,
- la figure 2 représente une variante de réalisation de la structure de guidage et des parois latérales du dispositif de mesure de la figure 1,
- la figure 3 représente un écran d'adaptation pour les antennes doublets du dispositif de mesure de la figure 1,
- la figure 4 représente une variante de réalisation de l'écran d'adaptation de la figure 3,
- les figures 5, 6, 7, 8, et 9 représentent chacune une variante de réalisation de la structure de guidage et des antennes de couplage du dispositif de mesure de la figure 1, et,
- la figure 10 représente, de façon détaillée, une variante de l'agencement des antennes doublets du dispositif de la figure 1.

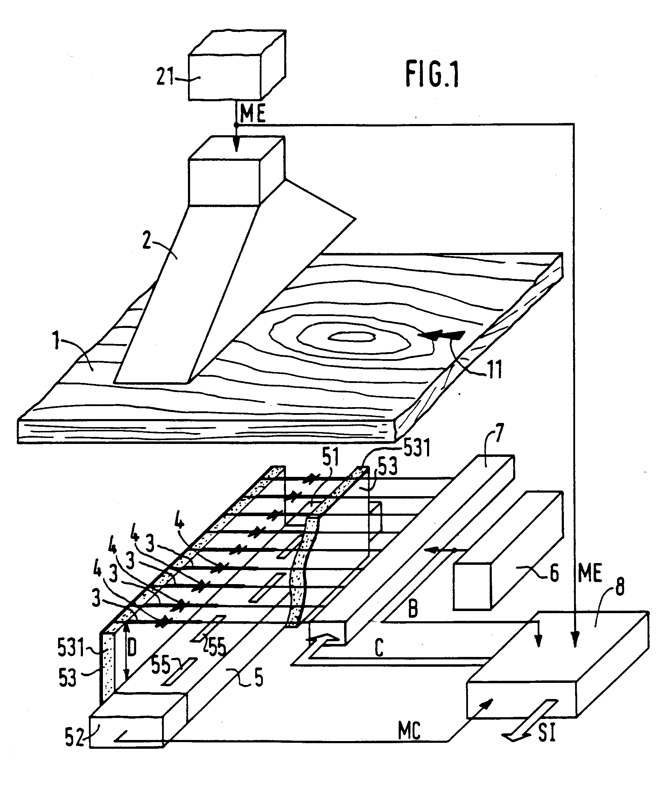

En se référant à la figure 1, un système de mesure permettant la détection des défauts d'une planche de bois 1 est maintenant décrit. La planche 1 défile, comme le montre la flèche 11, devant le système de mesure, fixe et agencé pour détecter les défauts de la planche afin de commander son découpage ultérieur de façon optimale, par exemple.

Une source de rayonnement micro-onde, en l'occurrence un cornet 2, est alimentée à l'aide d'un signal micro-onde ME, délivré par un générateur micro-onde 21. Le signal micro-onde ME est un signal à une seule fréquence.

Le cornet 2 illumine la planche 1 sur toute sa largeur. Un dispositif de mesure du champ micro-onde diffracté par la planche 1, champ diffracté qui est ici le champ transmis à travers cette planche 1, est donc disposé en regard du cornet 2, de l'autre côté de la planche 1, à une distance agrandie sur la figure pour des raisons évidentes de clarté.

Ce dispositif de mesure comprend tout d'abord une pluralité d'antennes 3, de type doublet électrique, c'est-à-dire comprenant chacune deux brins rectilignes égaux et alignés. La cathode d'une diode 4 est reliée à l'un des brins, tandis que son anode est reliée à l'autre brin, de façon à ce que chacune des antennes doublets 3 se trouve chargée en son centre par la diode 4, ici de type PIN. Les antennes doublets 3 sont disposées le long d'une ligne, ici perpendiculaire à la direction 11 de défilement de la planche, et correspondant à la zone allongée illuminée par le cornet 2.

Une structure de guidage, ici un guide rectangulaire 5 est disposée le long de la ligne d'antennes doublets 3, du côté opposé à la planche 1, et à une distance D égale, comme on le verra dans la suite, à quelques longueurs d'onde, à ladite fréquence micro-onde et dans le milieu dans lequel on travaille, ici de l'air.

Des fentes 55, dont les caractéristiques géométriques seront décrites plus en détail dans la suite, sont pratiquées dans le grand côté du guide 5 qui se trouve en regard de la ligne d'antennes doublets 3.

A une extrémité du guide 5 est montée une terminaison 51, ici un court circuit, tandis qu'à l'autre extrémité est montée une transition 52, du type connu guide-coaxial.

Deux parois 53, rigides et recouvertes d'une couche 531 de matériau absorbant les rayonnements micro-ondes à la fréquence de travail, sont disposées parallèlement à la ligne d'antennes doublets 3, de chaque côté du guide 5, pour fermer le volume situé entre le guide 5 et les antennes doublets 3. Le matériau absorbant employé est, par exemple, une mousse de matériau plastique chargée au carbone, de type courant, destinée à réduire les réflexions multiples entre le guide 5 et les antennes doublets 3.

Comme le montre la figure 1, chaque antenne doublet 3 a un brin relié à la masse électrique du système, ici et par exemple par soudage sur une des parois 53, réalisée à cet effet en métal et mise à la masse. L'autre brin de chaque antenne doublet 3 est relié ici à chacune des sorties d'un multiplexeur 7, qui reçoit sur son unique entrée un signal basse fréquence B issu d'un générateur 6.

Par "signal basse fréquence", on entend ici un signal périodique, carré ou sinusoïdal, dont la gamme de fréquence est considérablement plus basse que la gamme des fréquences habituellement appelées micro-onde. Ainsi, comme on peut admettre que la gamme micro-onde est limitée vers le bas à quelques centaines de" Megahertz, le signal B aura en principe une fréquence inférieure à quelques dizaines de Megahertz.

Un circuit électronique 8, géré à l'aide d'un microprocesseur, est pourvu de deux entrées micro-onde, recevant le signal micro-onde ME et un signal micro-onde MC délivré par la transition 52, d'une entrée basse fréquence recevant le signal B, d'une sortie numérique délivrant un signal C de commande du multiplexeur et d'une sortie délivrant un signal SI, représentatif du champ micro-onde mesuré et appliqué par exemple à un dispositif de visualisation non représenté car connu.

Le dispositif qui vient d'être décrit fonctionne comme suit.

A chaque instant, le microprocesseur du circuit électronique 8 commande le multiplexeur 7 pour que le signal B soit appliqué à une seule des diodes 4. Ainsi seule cette diode est polarisée, successivement en inverse et en direct, au rythme du signal B.

Simultanément, le rayonnement micro-onde illumine la planche 1, et le champ diffracté au niveau de chacune des antennes doublets 3 est un échantillon d'une image micro-onde de la tranche de planche illuminée.

Chaque fente 55 agit par ailleurs comme une antenne de couplage au guide 5, pour transformer le rayonnement qu'elle reçoit, et en particulier le rayonnement en provenance de l'ensemble des antennes doublets 3, en une onde guidée par le guide 5.

Les ondes guidées en provenance des différentes fentes 55 sont converties en le signal micro-onde MC par la transition 52. Ce signal micro-onde MC est appelé signal micro-onde collecté, puisqu'il résulte de la collecte des rayonnements reçus par les différentes fentes 55, et en particulier des rayonnements en provenance de l'ensemble des antennes doublets 3.

Dans le circuit électronique 8, le signal micro-onde collecté subit une détection synchrone micro-onde à l'aide du signal micro-onde ME, puis une seconde détection synchrone basse fréquence à l'aide du signal B. Or, parmi l'ensemble des rayonnements collectés, seul le rayonnement en provenance de l'antenne doublet 3, chargée par la diode polarisée par le signal B, se trouve modulé par ce signal B. De ce fait, le signal MC, après détection micro-onde, puis basse fréquence, n'est représentatif que du champ au point où se trouve l'antenne doublet 3 chargée par la diode 4 polarisée à l'aide du signal B. Le microprocesseur du circuit 8 peut donc commander la polarisation successive de chacune des diodes 4 et élaborer, à partir du signal C qui indique l'emplacement du point de mesure, et du signal résultant de la double détection qui indique la valeur du champ en ce point de mesure, un signal SI de commande d'un dispositif de visualisation.

Ce type de fonctionnement, qui résulte de la mise en oeuvre de la méthode connue par l'homme de métier sous le nom "méthode de diffusion modulée" est décrit dans le brevet américain déjà mentionné n° 4 552 151.

Ce type de fonctionnement n'est pas le seul envisageable pour le dispositif de l'invention. C'est ainsi que, en prévoyant, sur chacune des sorties du multiplexeur 7 un déphaseur basse fréquence commandable, on peut, en commandant le multiplexeur de telle sorte que les diodes soient polarisées simultanément, conformément à l'enseignement du brevet français N° 86 05 205, focaliser le dispositif sur un point intérieur d'une planche épaisse, permettant ainsi une représentation de type tomographique.

Le circuit électronique 8 qui comprend donc principalement, d'une part un microprocesseur de commande, et d'autre part un détecteur synchrone micro-onde suivi d'un détecteur synchrone basse fréquence, est à la portée de l'homme de métier et ne sera pas davantage décrit.

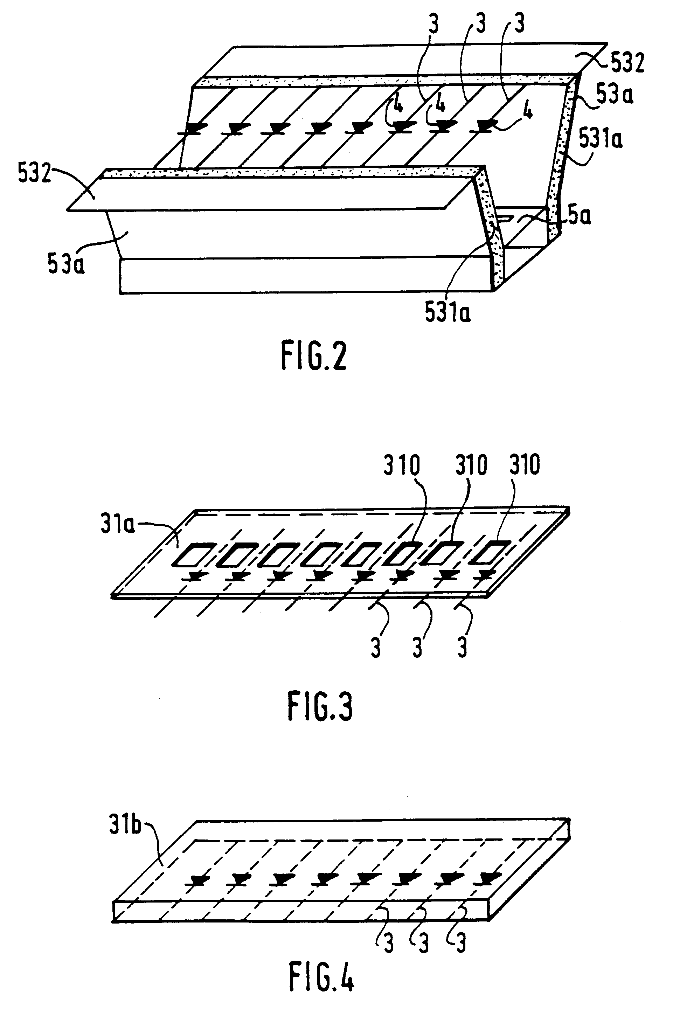

La figure 2 montre une variante de réalisation des parois latérales du dispositif de l'invention. Sur cette figure, le guide 5a est plus étroit que le guide 5 et les parois 531a latérales vont en s'évasant, et elles sont terminées par deux rebords métalliques 532 s'étendant dans le plan des antennes doublets 3.

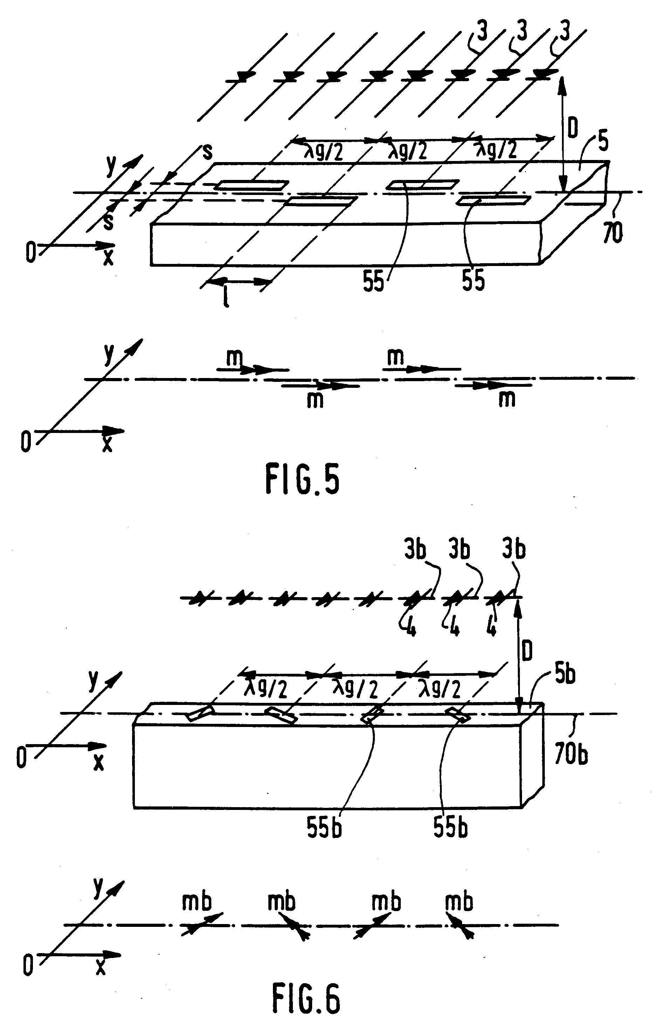

Sur les figures 3 et 4 sont montrées deux variantes de réalisation d'un écran d'adaptation qui peut être disposé entre la planche 1 et les antennes doublets 3.

Sur la figure 3, une plaque métallique 31a est pour-vue d'ouvertures 310 disposées en regard de chaque antenne doublet 3. La taille des ouvertures et leur distance aux antennes doublets sont déterminées, et ajustées expérimentalement, compte tenu de l'application considérée, pour obtenir une bonne adaptation des antennes, c'est-à-dire pour rendre minimale la puissance micro-onde réfléchie par les antennes doublets vers l'objet examine.

Sur la figure 4, une simple plaque diélectrique épaisse 31b est utilisée comme écran d'adaptation. Là encore, la constante diélectrique de la plaque, ainsi que son épaisseur, sont déterminées et ajustées expérimentalement pour obtenir une bonne adaptation.

La figure 5 représente de façon plus détaillée l'agencement des fentes 55 dans le guide 5 de la fière 1. Les fentes 55 sont pratiquées ici dans le grand côté du guide 5, et les antennes doublets 3 sont toutes perpendiculaires à la ligne selon laquelle elles sont disposées. Les fentes 55 sont longitudinales, de longueur $\ell$, et disposées alternativement de chaque côté de l'axe médian 70 du grand côté du guide, à une distance s de cet axe 70. Deux fentes successives sont distantes d'une demi-longueur d'onde guidée, soit $\lambda g/2$, à la fréquence de travail. Elles ont une longueur voisine de la longueur d'onde rayonnée, soit $\lambda/2$, à la fréquence de travail, et une largeur faible, mais dont la valeur n'est pas critique.

Le fonctionnement des antennes de couplage réalisées à l'aide des fentes 55 est plus facile à comprendre et à caractériser si l'on suppose que le cornet 2 ne rayonne pas, et si on suppose qu'un signal micro-onde est appliqué à la transition 52. Bien que l'utilisation pour laquelle est prévu le dispositif de l'invention ne corresponde pas à cette hypothèse de fonctionnement, on s'y ramène par le théorème de réciprocité, bien connu de l'homme de métier. Une telle hypothèse facilite la compréhension du fonctionnement des fentes.

Ici, donc, si on suppose qu'un signal micro-onde est appliqué à la transition 52, l'onde guidée dans le guide 5 est en opposition de phase en face de chacune des fentes successives 55, puisque celles-ci sont distantes de $\lambda g/2$. Toutefois, du fait de leur alternance par rapport à l'axe médian 70, les fentes 55 rayonnent toutes en phase. De plus, elles sont assez rapprochées pour créer un champ uniforme sur la ligne d'antennes doublets 3, disposée à la distance D de quelques longueurs d'ondes rayonnées $\lambda$. Alors, et comme cela a déjà été signalé, on peut disposer les antennes doublets 3 selon le pas qui est le mieux adapté à l'analyse de l'objet, indépendamment de la périodicité de la propagation dans le guide 5. Ici, et selon la finesse d'analyse souhaitée, le pas entre les antennes doublets 3 est compris entre quelques millimètres et quelques centimètres.

La distance s peut être déterminée par exemple de la façon suivante. Si le guide 5 comprend au total N fentes, chacune ayant une conductance réduite égale à g, une bonne adaptation impose :

$$g = {}^1/N$$

et on se reporte alors à des abaques pour déterminer, en fonction de la conductance réduite g, la valeur de la distance s. De tels abaques sont bien connus de l'homme de métier, et disponibles en particulier dans l'ouvrage suivant : "Antenna Engineering Handbook", Ed. Henry JASIK, Chap. 9 : Slot antenna arrays, MAC GRAW HILL, NEW YORK, 1984.

Comme le représente la partie inférieure de la figure 5, les fentes 55 sont équivalentes, dans le plan xOy du grand côté du guide 5, à des doublets magnétiques m perpendiculaires aux antennes doublets électriques 3.

La figure 6 représente une variante de réalisation où des antennes doublets 3b sont toutes parallèles à la ligne selon laquelle elles sont disposées. Un guide rectangulaire 5b, dans le petit côté duquel sont pratiquées des fentes 55b, est disposé pour que ces fentes 55b soient en regard des antennes doublets 3b. Les fentes 55b sont distantes de $\lambda g/2$ et forment, avec l'axe médian 70b du petit côté, des angles égaux et alternativement opposés. Les fentes 55b agissent comme des antennes de couplage équivalentes à des doublets magnétiques $m_b$. Elles rayonneraient en phase si un signal micro-onde était appliqué au guide 5b, et créeraient alors un champ dont la résultante, dans la direction des antennes doublets 3b, serait uniforme au niveau de ces antennes doublets 3b.

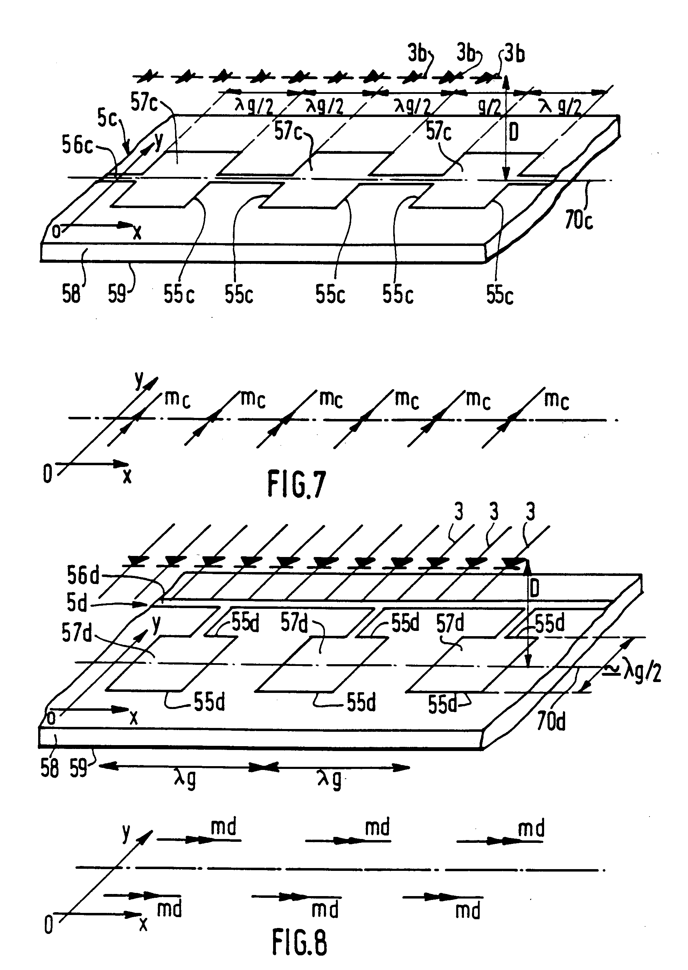

Sur la figure 7 est représentée une autre variante du dispositif de l'invention. Les antennes doublets 3b restent orientées comme dans l'exemple précédent, c'est-à-dire parallèles à leur alignement, mais la structure de guidage est maintenant une ligne à ruban 5c qui comprend, de façon connue, une plaque diélectrique 58, dont une face est revêtue d'une métallisation 59 reliée à la masse électrique, l'autre face supportant un ruban conducteur 56c. Comme le montre la figure 7, le ruban 56c est élargi périodiquement pour former des plaques métalliques rectangulaires 57c, raccordées donc en série à la ligne à ruban 5c. Il est connu que les bords 55c, perpendiculaires au ruban 56c, des rectangles 57c, sont équivalents, du fait de la déformation des lignes de champ, à des dipôles magnétiques $m_c$, qui sont donc ici perpendiculaires aux antennes doublets 3b. La ligne 5c est prévue pour que les bords 55c soient distants de $\lambda g/2$, de façon à ce que, comme il en va avec les fentes 55 du guide 5, elles rayonnent toutes en phase lorsqu'un signal micro-onde est appliqué à la ligne à ruban 5c.

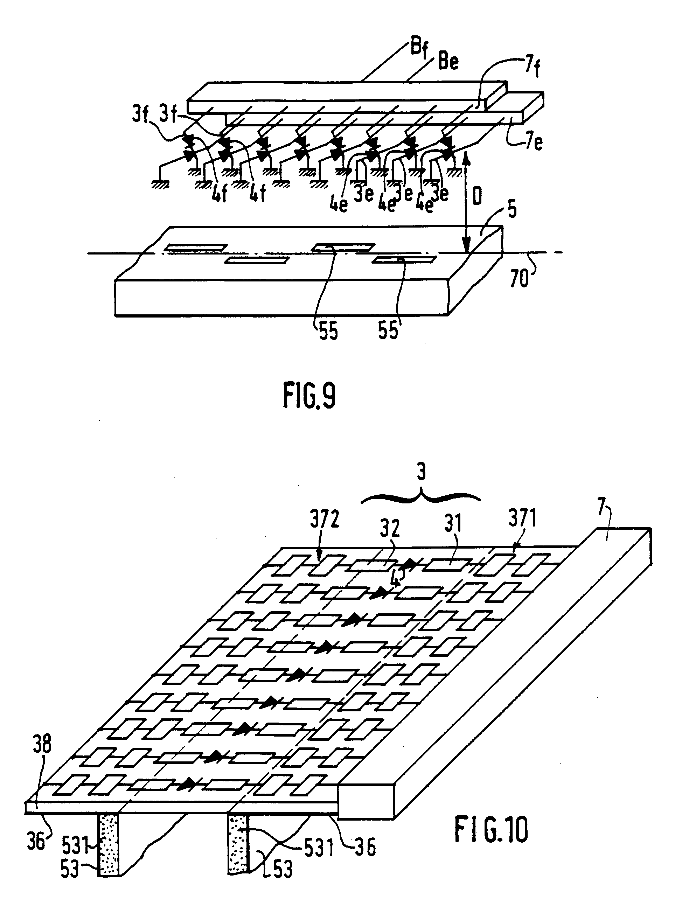

La figure 8 représente une autre variante où la structure de guidage est une ligne à ruban 5d, mais qui est agencée pour convenir aux antennes doublets 3, orientées perpendiculairement à leur alignement. Sur la figure 8, des plaques métalliques rectangulaires 57d sont raccordées en dérivation au ruban 56d de la ligne 5d, perpendiculairement à cette ligne 5d, de façon à ce que les deux bords 55d, parallèles à la ligne 5d, des plaques 57d agissent comme des doublets magnétiques $m_d$ perpendiculaires aux antennes doublets électriques 3. Là encore, la ligne 5d est dessinée pour que les antennes de couplage 55d soient alimentées en phase par un signal appliqué à la ligne 5d. Ici, les dérivations sont distantes d'une longueur d'onde guidée $\lambda g$ et les bords 55d sont distants de $\lambda g/2$.

Le fonctionnement de ces antennes à plaques- ("patch antennas") est décrit dans l'ouvrage déjà cité : "Antenna Engineering Handbook", Ed. Henry JASIK, Chap. 7: Microstrip antennas, MAC GRAW HILL, NEW-YORK, 1984.

Il est à noter que, s'il s'avère pratique de placer les antennes de couplage de façon à ce qu'elles soient distantes d'une demi-longueur d'onde guidée, en jouant sur les symétries de leurs emplacements pour qu'elles rayonnent en phase, ceci n'est pas obligatoire, et on peut les placer par exemple de façon à ce qu'elles soient distantes d'une longueur d'onde guidée, en les disposant alors à des emplacements identiques. Le seul critère à respecter est que les antennes de couplage doivent être disposées pour rayonner toutes en phase, à des emplacements suffisamment rapprochés pour que soit créé, dans ces conditions, un champ uniforme sur la ligne d'antennes doublets 3, la distance entre ces antennes doublets et la structure de guidage restant suffisante pour éviter les phénomènes de couplage.

Sur la figure 9 est représentée une variante du dispositif de l'invention, qui permet la mesure du champ diffracté selon deux polarisations orthogonales. Les antennes 3e d'une première série sont orientées à 45° par rapport à l'axe médian 70, chargées par des diodes 4e, et reliées à un multiplexeur 7e recevant un signal basse fréquence $B_e$, de fréquence $F_e$. Les antennes 3f d'une deuxième série sont orientées perpendiculairement aux antennes 3e, chargées par des diodes 4f, et reliées à un multiplexeur 7f recevant un signal basse fréquence $B_f$, de fréquence $F_f$. De façon non représentée, le signal micro-onde collecté subit, au lieu d'une unique détection synchrone basse fréquence, deux détections synchrones, une à la fréquence $F_e$, l'autre à la fréquence $F_f$, ce qui permet la détermination simultanée des deux composantes du champ en un point.

On pourrait également n'utiliser qu'un seul multiplexeur à un nombre double de voies, en polarisant successivement chacune des diodes 4e et 4f, afin de déterminer, successivement, les deux composantes du champ en un point.

Sur la figure 10 est représenté plus en détails un agencement des antennes doublets 3 et leur raccordement au multiplexeur 7. Une unique plaque 38 de diélectrique s'appuie sur l'extrémité supérieure des parois 53 recouvertes de leur couche 531 d'absorbant. Deux métallisations 36 sont prévues sous la plaque 38, de part et d'autre de la zone où se trouvent les antennes doublets 3. Sur la face supérieure de la plaque 38, les deux brins 31 et 32 de chaque antenne doublet 3 sont réalisés à l'aide d'un ruban conducteur supporté par la plaque 38.

La diode PIN 4 est raccordée à ces deux brins 31 et 32 qui se prolongent chacun en un filtre passe bas 371 et 372, respectivement, réalisés de façon connue, au-dessus des métallisations 36, en faisant varier la largeur du ruban pour obtenir une alternance de portions de ruban étroites et de portions de ruban larges. Les filtre passebas 371 sont reliés chacun à une sortie du multiplexeur 7 et les filtres passe-bas 372 sont tous reliés à la masse électrique. Les filtres passe-bas 371 et 372 se comportent comme des courts-circuits pour le Signal basse fréquence B et comme des circuits ouverts pour les signaux à la fréquence micro-onde.

Dans la description qui précède, on s'est toujours placé dans le cas où l'objet est traversé par le rayonnement microonde, c'est-à-dire dans le cas où le champ micro-onde diffracté est le champ transmis. Ceci n'est pas obligatoire, et on peut également mesurer, avec le dispositif de l'invention, le champ réfléchi par un objet illuminé à l'aide d'un rayonnement micro-onde, ou simultanément le champ transmis et le champ réfléchi, en utilisant éventuellement plusieurs dispositifs.

De même, sur la figure 1, on a représenté un cornet 2 pour l'illumination de la planche 1. Ceci n'est pas obligatoire, et on pourrait avantageusement utiliser, au lieu du cornet 2, une source de rayonnement micro-onde comprenant une structure de guidage pourvue d'antennes de couplage, identique à celle utilisée pour le collecteur, mais ne comportant pas, évidemment, d'antennes doublets. Une telle structure de guidage est alors placée à quelques longueurs d'onde de l'objet à illuminer.

Pour certaines applications, il est intéressant d'utiliser une source de rayonnement micro-onde à double polarisation.

Il n'est pas obligatoire d'utiliser des diodes PIN, et on peut les remplacer par des photodiodes polarisables par faisceau laser ou fibres optiques.

De même, les structures de guidages telles que les guides 5, 5a, 5b, et les lignes 5c et 5d ne sont pas obligatoirement terminées par un court-circuit. C'est ainsi qu'elles sont souvent terminées par une charge adaptée, comme cela est connu.

Dans le cas où l'objet n'est pas en défilement, et ou l'on souhaite disposer d'une image bidimensionnelle de l'objet, il est évidemment possible de juxtaposer plusieurs dispositifs conformes au dispositif ci-dessus.

La procédure de détermination, expérimentale, de la distance D est la suivante, en référence à la figure 1. En n'interposant aucun objet comme la planche 1 entre le cornet 2 et les antennes doublets 3, on illumine ces dernières de façon uniforme. Tandis que le circuit 8 commande successivement la polarisation de chacune des diodes 4 à l'aide du signal B, comme cela a été décrit, on éloigne le guide 5, à partir d'une position où il se trouve contre les antennes doublets 3, en observant le signal visualisé. Au départ, on retrouve des oscillations correspondant à la périodicité de répartition des fentes 55, mais ces oscillations s'atténuent au fur et à mesure de l'augmentation de la distance D. Concomitamment, le niveau du signal reçu décroit. On s'arrête lorsque le champ est uniforme sur la ligne d'antennes doublets, c'est-à-dire lorsque les ondulations résiduelles sont assez faibles pour être compatibles avec la précision requise. En général, ce résultat est obtenu pour une distance D de l'ordre de quelques longueurs d'ondes. On notera que, par une calibration convenable, on peut corriger les défauts du dispositif.

Naturellement, le dispositif peut être utilisé pour tester le champ rayonne par des applicateurs industriels, et des antennes de télécommunications ou de radar, éventuellement pourvues de radomes.

**Revendications**

1. Dispositif de mesure, en une pluralité de points, du champ micro-onde diffracté par un objet (1) illuminé par une source (2) de rayonnement micro-onde à une fréquence, et comprenant :
   - en chacun desdits points, une antenne (3) de type doublet électrique, chargée en son centre par une diode (4),
   - lesdites antennes doublets (3) sont disposées le long d'au moins une ligne,
   - des moyens collecteurs (5) du rayonnement micro-onde diffracté, délivrant un signal micro-onde collecté (MC),
   - des moyens générateurs (6) d'un signal basse fréquence (B),
   - des moyens multiplexeurs (7), disposés entre lesdits moyens générateurs (6) et chacune desdites diodes (4), et,
   - des moyens (8) pour commander lesdits moyens multiplexeurs (7) de façon à ce qu'au moins une desdites diodes (4) soit polarisée par ledit signal basse fréquence (B), et
   pour, en réponse audit signal basse fréquence (B) et audit signal micro-onde collecté (MC), engendrer un signal (SI) représentatif du champ micro-onde au point où se trouve ladite antenne doublet (3) chargée par ladite diode polarisée,
   dispositif de mesure caractérisé par le fait que :
   - lesdits moyens collecteurs comprennent une unique structure de guidage (5) micro-onde, disposée le long de ladite ligne d'antennes doublets (3), du côté opposé audit objet (1), à une distance (D) desdites antennes doublets (3),
   - il est prévu, le long de ladite structure de guidage (5), une pluralité d'antennes de couplage (55) à ladite structure de guidage (5), chaque antenne de couplage (55) transformant le rayonnement micro-onde qu'elle reçoit en une onde guidée par ladite structure de guidage (5),
   - une extrémité de ladite structure de guidage (5) est pourvue d'une terminaison (51) et l'autre extrémité de moyens de conversion (52) desdites ondes guidées en ledit signal micro-onde collecté (MC),

- lesdites antennes de couplage (55) sont disposées à des emplacements tels qu'elles rayonneraient toutes en phase si, ladite source (2) étant éteinte, un unique signal micro-onde était appliqué auxdits moyens de conversion (52),
- ladite distance (D) entre les antennes doublets (3) et la structure de guidage (5) est déterminée pour que soit crée, dans ces conditions, un champ uniforme sur ladite ligne d'antennes doublets (3).

2. Dispositif de mesure selon la revendication 1, dans lequel le volume situé entre ladite structure de guidage (5; 5a) et lesdites antennes doublets (3) est fermé par deux parois (53; 53a) parallèles à ladite ligne, et recouvertes d'une couche (531, 531a) de matériau absorbant les rayonnements à ladite fréquence micro-onde.

3. Dispositif de mesure selon la revendication 3, dans lequel lesdites parois (53a) sont terminées par deux rebords métalliques (532) s'étendant dans le plan desdites antennes doublets (3).

4. Dispositif de mesure selon l'une des revendications 1 à 3, dans lequel il est prévu, entre ledit objet (1) et lesdites antennes doublets (3) un écran d'adaptation (31a; 31b).

5. Dispositif de mesure selon la revendication 4, dans lequel l'écran d'adaptation est une plaque métallique (31a) pourvue d'ouvertures (310) disposées en regard de chacune desdites antennes doublets (3).

6. Dispositif de mesure selon la revendication 4, dans lequel l'écran d'adaptation est une plaque diélectrique épaisse (31b).

7. Dispositif de mesure selon l'une des revendications 1 à 6, dans lequel ladite structure de guidage est un guide d'ondes métallique (5; 5b) creux, et lesdites antennes de couplage sont des fentes (55; 55b) pratiquées dans la paroi dudit guide d'ondes (5; 5b).

8. Dispositif de mesure selon l'une des revendications 1 à 6, dans lequel ladite structure de guidage est une ligne à ruban (5c; 5d) et lesdites antennes de couplage sont les bords (55c; 55d) de plaques métalliques rectangulaires (57c; 57d) raccordées à ladite ligne à ruban (5c; 5d).

9. Dispositif de mesure selon l'une des revendications 1 à 8, dans lequel lesdites antennes doublets (3) sont toutes perpendiculaires à ladite ligne le long de laquelle elles sont disposées.

10. Dispositif de mesure selon l'une des revendications 1 à 8, dans lequel lesdites antennes doublets (3b) sont toutes parallèles à ladite ligne le long de laquelle elles sont disposées.

11. Dispositif de mesure selon l'une des revendications 9 ou 10, dans lequel lesdites antennes de couplage (55; 55c; 55d) sont équivalentes à des doublets magnétiques $(m; m_c, m_d)$. Perpendiculaires auxdites antennes doublets (3) électriques.

12. Dispositif de mesure selon l'une des revendications 1 à 11, dans lequel lesdits moyens multiplexeurs (7) sont raccordés à chacune desdites diodes (4) par l'intermédiaire de l'un (31) des deux brins de l'antenne doublet (3) que charge cette diode (4), un premier filtre passe-bas (371) étant disposé entre lesdits moyens multiplexeurs (7) et ledit brin (31), l'autre (32) des deux brins de ladite antenne doublet (3) étant reliée à la masse par l'intermédiaire d'un deuxième filtre passe-bas (372).

13. Dispositif de mesure selon la revendication 12, dans lequel ledit premier filtre passe-bas (371), ledit premier brin (31), ledit deuxième brin (32) et ledit deuxième filtre passe-bas (372) sont réalisés à l'aide d'un même ruban conducteur dont la largeur varie, supporté par une plaque (38) de diélectrique pourvue de métallisations (36) reliées à la masse, et disposées sous lesdits premier et deuxième (372) filtres passe-bas.

14. Dispositif de mesure selon l'une des revendications 1 à 13, dans lequel ladite source de rayonnement micro-onde comprend une structure de guidage pourvue d'antennes de couplage, identique à la structure de guidage utilisée dans lesdits moyens collecteurs.

15. Dispositif selon l'une des revendications 1 à 8, dans lequel lesdites antennes doublets (3e, 3f) comprennent deux séries d'antennes doublets, chaque antenne (3e) d'une série étant orthogonale à une antenne (3f) de l'autre série, lesdits moyens générateurs (6), lesdits moyens multiplexeurs (7) et lesdits moyens (8) de commande et de génération dudit signal (SI) représentatif du champ micro-onde étant agencés pour mesurer deux composantes orthogonales du champ micro-onde.

**Claims**

1. A device for measuring, at a plurality of points, the microwawe field diffracted by an object (1) illuminated by a microwave radiation source (2) at a frequency, and comprising:
   - at each of said points an electric doublet type antenna (3) loaded at its center by a diode (4),
   - said doublet antennae (3) are disposed along at least one line,
   - means (5) for collecting the diffracted microwave radiation and delivering a collected microwave signal (MC),
   - means (6) for generating a low frequency signal (B),
   - multiplexing means (7), disposed between said generating means (6) and each of said diodes (4), and
   - means (8) for controlling said multiplexing means (7) so that at least one of said diodes (4) is biassed by said low frequency signal (B) and in response to said low frequency signal (B) and said collected microwave signal (MC), for generating a signal (SI) representative of the microwave field at the point where said doublet antenna (3) loaded by said biassed diode is located,

   measuring device characterized in that:
   - said collector means comprise a single microwave guide structure (5), disposed along said doublet antennae (3) line, on the side opposite said object (1) at a distance (D) from said doublet antennae (3),
   - along said guide structure (5) is provided a plurality of antennae (55) for coupling to said guide structure (5), each coupling antenna (55) transforming the microwave radiation which it receives into a wave guided by said guide structure (5),
   - one end of said guide structure (5) is provided with a termination (51) and the other end with means (52) for converting said guided waves into said collected microwave signal (MC),
   - said coupling antennae (55) are disposed at positions such that they would all radiate in phase if, with said source (2) extinguished, a single microwave signal were applied to said conversion means (52),
   - said distance (D) between the doublet antennae (3) and said guide structure (5) is determined so that, under these conditions, a uniform field is created on said doublet antennae (3) line.

2. The measuring device as claimed in claim 1, wherein the volume situated between said guide structure (5;5a) and said doublet antennae (3) is closed by two walls (53;53a) parallel to said line and covered with a layer (531;531a) of material absorbing the radiation at said microwave frequency.

3. The measuring device as claimed in claim 3, wherein said walls (53a) are terminated by two metal flanges (532) extending in the plane of said doublet antennae (3).

4. The measuring device as claimed in claims 1 to 3, wherein, between said object (1) and doublet antennae (3), there is provided a matching screen (31a;31b).

5. The measuring device as claimed in claim 4, wherein said matching screen is a metal plate (31a) provided with openings (310) disposed opposite each of said doublet antennae (3).

6. The measuring device as claimed in claim 4, wherein said matching screen is a thick dielectric plate (31b).

7. The measuring device as claimed in claims 1 to 6, wherein said guide structure is a hollow metal waveguide (5;5b) and said coupling antennae are slots (55,55b) formed in the wall of said waveguide (5;5b).

8. The measuring device as claimed in claims 1 to 6, wherein said guide structure is a microstrip line (5c;5d) and said coupling antennae are the edges (55c;55d) of rectangular metal plates (57c;57d) connected to said microstrip line (5c;5d).

9. The measuring device as claimed in claims 1 to 8, wherein said doublet antennae (3) are all perpendicular to said line along which they are disposed.

10. The measuring device as claimed in claims 1 to 8, wherein said doublet antennae (3b) are all parallel to said line along which they are disposed.

11. The measuring device as claimed in claim 9 or 10, wherein said coupling antennae (55;55c;55d) are equivalent to magnetic doublets (m;mc;md) perpendicular to said electric doublet antennae (3).

12. The measuring device as claimed in claims 1 to 11, wherein said multiplexing means (7) are connected to each of said diodes (4) by means of one (31) of the two sections of the doublet antennae (3) which this diode (4) loads, a first low pass filter (371) being disposed between said multiplexing means (7) and said section (31), the other (32) of the two sections of said doublet antenna (3) being connected to ground through a second low pass filter (372).

13. The measuring device as claimed in claim 12, wherein said first low pass filter (371), said first section (31), said second section (32) and said second low pass filter (372) are formed by means of the same conducting microstrip whose width varies, supported by a dielectric plate (38) having metallizations (36) connected to ground and disposed under said first and second low pass filters.

14. The measuring device as claimed in claims 1 to 13, wherein said microwave radiation source comprises a guide structure having coupling antennae, identical to the guide structure used for said collector means.

15. The measuring device as claimed in claims 1 to 8, wherein said doublet antennae (3e,3f) comprise two series of doublet antennae, each antenna (30) of a series being orthogonal to an antenna (3f) of the other series, said generator means (6), said multiplexing means (7) and said means (8) for controlling and generating said signal (SI) representative of the microwave field being adapted so as to measure two orthogonal components of the microwave field.

**Patentansprüche**

1. Vorrichtung zur Ausmessung des von einem Objekt (1) gestreuten Mikrowellenfeldes an einer Vielzahl von Punkten, wobei das Objekt von einer Strahlungsquelle (2), die Mikrowellen einer Frequenz aussendet, angestrahlt wird, welche Vorrichtung umfaßt:
   - an jedem der Punkte eine Antenne (3) von der Art eines elektrischen Dipols, die in ihrer Mitte durch eine Diode (4) aufgeladen wird, wobei die Dipolantennen (3) entlang mindestens einer Linie angeordnet sind,
   - Sammelmittel (5) für die gestreute Mikrowellenstrahlung, die ein gesammeltes Mikrowellensignal (MC) liefern,
   - Mittel zur Erzeugung (6) eines Niederfrequenzsignales (B),
   - Mehrfachkopplungsmittel (7), die zwischen den Erzeugungsmitteln (6) und jeder der Dioden (4) angeordnet sind, und
   - Mittel (8) um diese Mehrfachkopplungsmittel (7) so zu steuern, daß mindestens eine der Dioden (4) durch das Niederfrequenzsignal (B) polarisiert wird, und um in Abhängigkeit von dem Niederfrequenzsignal (B) und dem gesammelten Mikrowellensignal (MC) ein Signal (SI) zu erzeugen, welches das Mikrowellenfeld repräsentiert, das an dem Punkt herrscht, an dem sich die von der polarisierten Diode aufgeladene Dipolantenne (3) befindet,

eine Meßvorrichtung, dadurch gekennzeichnet, daß
   - die Sammelmittel eine einzige Mikrowellenleitstruktur (5) umfassen, die entlang der Linie der Dipolantennen (3) auf der dem Objekt (1) entgegengesetzten Seite in einer Entfernung (D) von den Dipolantennen (3) angeordnet ist,
   - entlang der Leitstruktur (5) eine Vielzahl von Antennen (55) zur Kopplung mit der Leitstruktur (5) vorgesehen ist, wobei jede Kopplungsantenne (55) die von ihr empfangene Mikrowellenstrahlung in eine von der Leitstruktur (5) geleitete Welle umwandelt,
   - ein Ende der Leitstruktur (5) mit einem Abschluß (51) und das andere Ende mit Mitteln zur Umwandlung (52) der geleiteten Wellen in das gesammelte Mikrowellensignal (MC) versehen ist,
   - die Kopplungsantennen (55) an solchen Stellen angeordnet sind, daß sie sämtlich in Phase abstrahlen würden, wenn bei erloschener Quelle (2) ein einziges Mikrowellensignal an die Umwandlungsmittel (52) angelegt würde,
   - die Entfernung (D) zwischen den Dipolantennen (3) und der Leitstruktur (5) so festgelegt ist, daß unter diesen Bedingungen an der Linie der Dipolantennen (3) ein gleichförmiges Feld geschaffen wird.

2. Meßvorrichtung nach Anspruch 1, bei der das zwischen der Leitstruktur (5; 5a) und den Dipolantennen (3) befindliche Volumen durch zwei Wände (53; 53a) abgeschlossen wird, die parallel zur vorgenannten Linie verlaufen und mit einer Schicht (531, 531a) aus einem Material versehen sind, das die Mikrowellenstrahlungen der besagten Frequenz absorbiert.

3. Meßvorrichtung nach Anspruch 2, bei der die Wände (53a) mit zwei sich in der Ebene der Dipolantennen (3) erstreckenden Metallrändern (532) abschließen.

4. Meßvorrichtung nach einem der Ansprüche 1 bis 3, bei der zwischen dem Objekt (1) und den Dipolantennen (3) ein Adaptationsschirm (31a; 31b) vorgesehen ist.

5. Meßvorrichtung nach Anspruch 4, bei der der Adaptationsschirm eine Metallplatte (31a) ist, die mit Öffnungen (310) versehen ist, welche jeweils einer der Dipolantennen (3) gegenüberliegen.

6. Meßvorrichtung nach Anspruch 4, bei der der Adaptationsschirm eine dicke dielektrische Platte (31b) ist.

7. Meßvorrichtung nach einem der Ansprüche 1 bis 6, bei der die Leitstruktur ein hohler metallischer Wellenleiter (5; 5b) ist und die Kopplungsantennen in der Wand des Wellenleiters (5; 5b) vorgesehene Spalte (55; 55b) sind.

8. Meßvorrichtung nach einem der Ansprüche 1 bis 6, bei der die Leitstruktur eine Bandleitung (5c; 5d) ist und die Kopplungsantennen die Ränder (55c; 55d) rechteckiger, mit der Bandleitung (5c; 5d) verbundener Metallplatten (57c; 57d) sind.

9. Meßvorrichtung nach einem der Ansprüche 1 bis 8, bei der die Dipolantennen (3) sämtlich senkrecht zur Linie, an der sie angeordnet sind, ausgerichtet sind.

10. Meßvorrichtung nach einem der Ansprüche 1 bis 8, bei der die Dipolantennen (3b) sämtlich parallel zur Linie, an der sie angeordnet sind, ausgerichtet sind.

11. Meßvorrichtung nach einem der Ansprüche 9 oder 10, bei der die Kopplungsantennen (55; 55c; 55d) magnetischen Dipolen ($m$; $m_c$; $m_d$) entsprechen, die senkrecht zu den elektrischen Dipolantennen (3) ausgerichtet sind.

12. Meßvorrichtung nach einem der Ansprüche 1 bis 11, bei der die Mehrfachkopplungsmittel (7) an jede der Dioden (4) angeschlossen sind, und zwar über einen (31) der zwei Drähte der Dipolantenne (3), die diese Diode (4) auflädt, wobei ein erster Tiefpaßfilter (371) zwischen den Mehrfachkopplungsmitteln (7) und dem Draht (31) angeordnet ist und der andere (32) der zwei Drähte der Dipolantenne (3) über einen zweiten Tiefpaßfilter (372) mit der Masse verbunden ist.

13. Meßvorrichtung nach Anspruch 12, bei der der erste Tiefpaßfilter (371), der erste Draht (31), der zweite Draht (32) und der zweite Tiefpaßfilter (372) mittels eines selben Bandleiters realisiert sind, dessen Breite variiert und der von einer dielektrischen Platte (38) getragen wird, die mit Metallüberzügen (36) versehen ist, welche mit der Masse verbunden und unter dem ersten und dem zweiten (372) Tiefpaßfilter angeordnet sind.

14. Meßvorrichtung nach einem der Ansprüche 1 bis 13, bei der die Mikrowellenstrahlungsquelle eine Leitstruktur umfaßt, die mit Kopplungsantennen versehen ist und mit der bei den Sammelmitteln verwendeten Leitstruktur identisch ist.

15. Vorrichtung nach einem der Ansprüche 1 bis 8, bei der die Dipolantennen (3e, 3f) zwei Reihen von Dipolantennen umfassen, wobei jede Antenne (3e) der einen Reihe rechtwinklig zu einer Antenne (3f) der anderen Reihe ausgerichtet ist und wobei die Erzeugungsmittel (6), die Mehrfachkopplungsmittel (7) und die Mittel (8) zur Steuerung und zur Erzeugung des das Mikrowellenfeld repräsentierenden Signals (SI) dafür vorgesehen sind, zwei orthogonale Komponenten des Mikrowellenfeldes zu messen.

FIG.1

FIG.2

FIG.3

FIG.4

FIG.5

FIG.6

FIG.7

FIG.8

FIG.9

FIG.10